# EUROPÄISCHE PATENTANMELDUNG

(11) **EP 1 239 516 A1**
(43) Veröffentlichungstag der Anmeldung: **11.09.2002**
(21) Anmeldenummer: 02003539.0
(22) Anmeldetag: 15.02.2002
(51) Int. Cl.: H01L 23/467, H05K 7/20, G06F 1/20, H02P 7/00

(54) **Temperatur-Überwachungsvorrichtung für Mikroprozessor-Kühleinrichtungen**

(30) Priorität: 15.02.2001 DE 10107492
(71) Anmelder: SEESEMANN, MATTHIAS, 61273 WEHRHEIM (DE)
(72) Erfinder: SEESEMANN, MATTHIAS, 61273 WEHRHEIM (DE)
(74) Vertreter: Kiessling, Christian

(57) **Zusammenfassung**

Bei einer Temperatur-Überwachungsvorrichtung für Mikroprozessoren, mit einer elektromotorisch getriebenen Ventilatoreinrichtung zum Erzeugen eines Luftstromes zum Kühlen des Mikroprozessors wird dadurch, dass die Temperatur des Mikroprozessors mittels eines in einer in dem Boden eines Kühlkörpers des Mikroprozessors ausgebildeten Bohrung angeordneten Wärmemesssensors sensierbar ist und eine Regelungsschaltung vorgesehen ist, die aufgrund der von dem Wärmemesssensor sensierten Temperatur die Drehzahl des Elektromotors der Ventilatoreinrichtung mit steigender Temperatur erhöht und mit sinkender Temperatur mindert, indem sie die Frequenz eines Oszillators regelt, dessen Ausgang mit den Wicklungsspulen des Stators des bürstenlos ausgebildeten Elektromotors verbunden ist, erreicht, dass die Temperatur eines Mikroprozessors innerhalb vorgebbarer Grenzen einstellbar ist.

## Beschreibung

Die Erfindung betrifft eine Temperatur-Überwachungsvorrichtung für Mikroprozessoren, mit einer elektromotorisch getriebenen Ventilatoreinrichtung zum Erzeugen eines Luftstromes zum Kühlen des Mikroprozessors. Die erfindungsgemäße Temperatur-Überwachungsvorrichtung kann des weiteren für Desktop Personal Computer oder ähnliche, temperaturempfindliche Vorrichtungen verwendet werden.

Temperatur-Überwachungsvorrichtung der eingangs genannten Art sind im Stand der Technik bekannt. Die bekannten Temperatur-Überwachungsvorrichtungen weisen jedoch insgesamt den Nachteil auf, dass die Temperatur der Mikroprozessoren nur innerhalb vergleichsweise breiter Temperaturbereiche gehalten werden kann und nicht weitestgehend konstant gehalten werden kann. Dadurch werden Betriebsausfälle mitverursacht.

Aufgabe der Erfindung ist es deshalb, eine Temperatur-Überwachungsvorrichtung für Mikroprozessoren zu schaffen, mittels derer die Temperatur eines Mikroprozessors innerhalb vorgebbarer Grenzen einstellbar ist.

Für eine Temperatur-Überwachungsvorrichtung der eingangs genannten Art wird diese Aufgabe dadurch gelöst, dass die Temperatur des Mikroprozessors mittels eines in einer in dem Boden eines Kühlkörpers des Mikroprozessors ausgebildeten Bohrung angeordneten Wärmemesssensors sensierbar ist und eine Regelungsschaltung vorgesehen ist, die aufgrund der von dem Wärmemesssensor sensierten Temperatur die Drehzahl des Elektromotors der Ventilatoreinrichtung mit steigender Temperatur erhöht und mit sinkender Temperatur mindert, indem sie die Frequenz eines Oszillators regelt, dessen Ausgang mit den Wicklungsspulen des Stators des bürstenlos ausgebildeten Elektromotors verbunden ist.

Bevorzugte Ausführungsformen der Erfindung sind Gegenstand der Unteransprüche.

Bei der erfindungsgemäßen Temperatur-Überwachungsvorrichtung wird durch das Merkmal, dass die Temperatur des Mikroprozessors mittels eines in einer in dem Boden eines Kühlkörpers des Mikroprozessors ausgebildeten Bohrung angeordneten Wärmemesssensors sensierbar ist und eine Regelungsschaltung vorgesehen ist, die aufgrund der von dem Wärmemesssensor sensierten Temperatur die Drehzahl des Elektromotors der Ventilatoreinrichtung mit steigender Temperatur erhöht und mit sinkender Temperatur mindert, indem sie die Frequenz eines Oszillators regelt, dessen Ausgang mit den Wicklungsspulen des Stators des bürstenlos ausgebildeten Elektromotors verbunden ist, erreicht, dass eine Vorrichtung geschaffen ist, bei der für den Fall, dass eine Temperatur des Mikroprozessors festgestellt wird, die sich außerhalb eines vorgegebenen Temperaturbereiches befindet, die Ventilatoreinrichtung vorgebbar so steuerbar ist, dass eine definierte zusätzliche Kühlung erzeugbar ist, die eine Abkühlung der Temperatur des Mikroprozessors in den vorgegebenen Temperaturbereichbewirkt. Der die Temperatur des Mikroprozessors sensierende Wärmemesssensor ist dabei in einer in dem Boden eines Kühlkörpers des Mikroprozessors ausgebildeten Bohrung angeordnet, um eine möglichst genaue Temperaturmessung zu erreichen.

Gemäß einer ersten bevorzugten Ausführungsform der erfindungsgemäßen Vorrichtung ist vorgesehen, dass die Drehzahl des Elektromotors proportional mit einer Temperaturerhöhung des Mikroprozessors steigt. Je nach Größe und Leistungsfähigkeit des Mikroprozessors sowie der Ventilatoreinrichtung kann die Drehzahl des Elektromotors dabei alternativ quadratisch oder exponentiell mit einer Temperaturerhöhung des Mikroprozessors steigen.

Gemäß einer weiteren bevorzugten Ausführungsform der erfindungsgemäßen Vorrichtung ist vorgesehen, dass eine Drehzahlüberwachungseinrichtung zum Überwachen eines vorgebbaren Drehzahlbereiches des Elektromotors der Ventilatoreinrichtung vorgesehen ist. Dadurch ist eine zusätzliche Sicherheitseinheit gegeben.

Die Drehzahlüberwachungseinrichtung gibt dabei vorzugsweise im Zusammenwirken mit einer elektronischen Schaltung ein Warnsignal ab, um einen Benutzer einer mit dem Mikroprozessor betriebenen Vorrichtung zum manuellen Abschalten derselben aufzufordern, wenn der vorgegebene Drehzahlbereich der Ventilatoreinrichtung verlassen ist.

Gemäß einer wichtigen bevorzugten Ausführungsform der erfindungsgemäßen Vorrichtung ist vorgesehen, dass die Drehzahlüberwachungseinrichtung zum Überwachen eines vorgebbaren Drehzahlbereiches der Ventilatoreinrichtung eine Einrichtung enthält, die ein mit der Umdrehungsfrequenz des Ventilators der Ventilatoreinrichtung getaktetes Stroboskopsignal liefert, sowie eine mit einer vorgegebenen Frequenz getaktete Einrichtung zum Auswerten des Stroboskopsignals enthält. Dadurch ist eine sehr genaue Drehzahlüberwachung gewährleistet.

Bei der erfindungsgemäßen Vorrichtung ist der Oszillator vorzugsweise im Inneren der Ventilatoreinrichtung untergebracht. Des weiteren ist die Ventilatoreinrichtung vorzugsweise an dem Kühlkörper des Mikroprozessors angeordnet.

Gemäß einer weiteren bevorzugten Ausführungsform der erfindungsgemäßen Vorrichtung ist vorgesehen, dass die Ventilatoreinrichtung dimensioniert ist, um in der Lage zu sein, eine Luftmenge etwa 80 m³/Stunde zu fördern.

Der Wärmemesssensor der erfindungsgemäßen Vorrichtung ist vorzugsweise als NTC-Thermistor ausgeführt, wobei der NTC-Widerstand funktional als Regelungsschaltung wirken kann.

Die erfindungsgemäße Temperatur-Überwachungsvorrichtung für Mikroprozessoren wird im folgenden anhand einer bevorzugten Ausführungsform erläutert, die in der Figur der Zeichnung dargestellt ist. Darin zeigt:

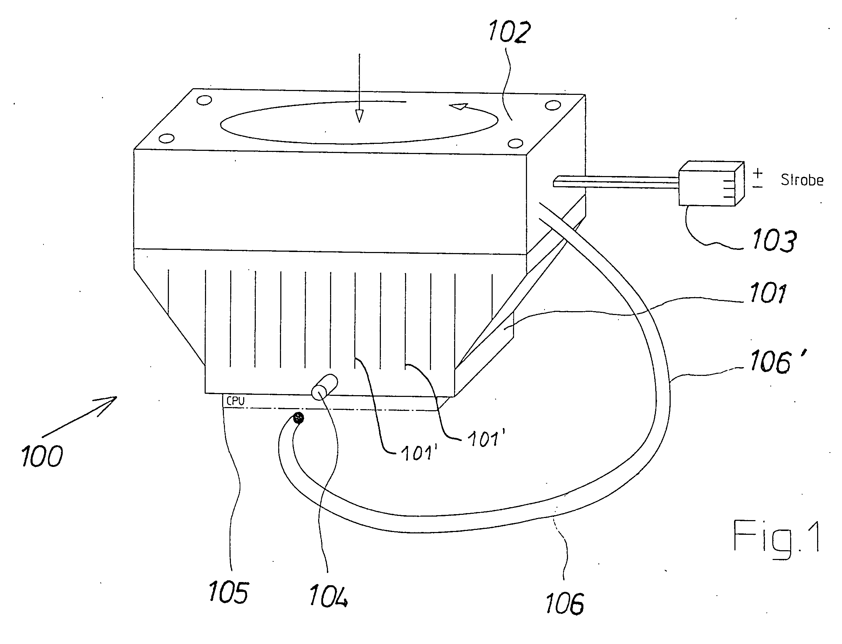

- Fig.1: eine bevorzugte Ausführungsform der erfindungsgemäßen Temperatur-Überwachungsvorrichtung in einer Ansicht von schräg oben.

Die erfindungsgemäße Temperatur-Überwachungsvorrichtung 100 für Mikroprozessoren weist eine Ventilatoreinrichtung 102 zum Erzeugen eines Luftstromes zum Kühlen eines Mikroprozessors 105 auf, wobei die Ventilatoreinrichtung auf einem mit Kühlrippen 101' versehenen massivem Block 101 angeordnet ist, der über eine gemeinsame Kontaktfläche wärmeleitend mit dem Mikroprozessor 105 verbunden ist. Die Temperatur des Mikroprozessors 105 wird mittels eines Wärmemesssensors 104 sensiert, der in einem Raumbereich nahe der Kontaktfläche des Mikroprozessors 105 mit dem Block 101 angebracht ist.

Bei der dargestellten Ausführungsform der erfindungsgemäßen Temperatur-Überwachungsvorrichtung 100 ist der Wärmemesssensor 104 als NTC-Widerstand ausgeführt. Dadurch ist das Vorsehen einer gesonderten Regelungsschaltung entbehrlich, da der NTC-Widerstand über Leitungen 106, 106' so in den Stromkreis der Ventilatoreinrichtung 102 geschaltet ist, dass er funktional als Regelungsschaltung wirkt um die Geschwindigkeit der Ventilatoreinrichtung 102 mit steigender Temperatur linear zu erhöhen bzw. bei fallender Temperatur linear zu mindern, indem entsprechend die Frequenz eines in der Ventilatoreinrichtung untergebrachten Oszillators geregelt wird, dessen Ausgang mit den Wicklungsspulen des Stators des bürstenlos ausgebildeten Elektromotors verbunden ist.

Zusätzlich zu der Drehzahlregelung durch den als NTC-Widerstand ausgeführten Wärmemesssensor 104 ist eine Drehzahlüberwachungseinrichtung 103 zum Überwachen eines vorgebbaren Drehzahlbereiches der Ventilatoreinrichtung 102 vorgesehen, die im Zusammenwirken mit einer nicht dargestellten elektronischen Schaltung bzw. geeigneter Software ein Warnsignal abgibt, um einen Benutzer einer mit der Mikroprozessor 105 betriebenen Vorrichtung zum manuellen Abschalten derselben aufzufordern, wenn der vorgegebene Drehzahlbereich der Ventilatoreinrichtung 102 verlassen ist.

Die Ventilatoreinrichtung 102 ist so dimensioniert, dass sie eine Leistung aufzubringen in der Lage ist, um eine Luftmenge etwa 80 m³/Stunde zu fördern.

Das oben erläuterte Ausführungsbeispiel der Erfindung dient lediglich dem Zweck eines besseren Verständnisses der durch die Ansprüche definierten erfindungsgemäßen Lehre, die als solche durch das Ausführungsbeispiel nicht eingeschränkt ist.

## Patentansprüche

**1.** Temperatur-Überwachungsvorrichtung für Mikroprozessoren, mit einer elektromotorisch getriebenen Ventilatoreinrichtung zum Erzeugen eines Luftstromes zum Kühlen des Mikroprozessors, **dadurch gekennzeichnet, dass** die Temperatur des Mikroprozessors mittels eines in einer in dem Boden eines Kühlkörpers des Mikroprozessors ausgebildeten Bohrung angeordneten Wärmemesssensors sensierbar ist und eine Regelungsschaltung vorgesehen ist, die aufgrund der von dem Wärmemesssensor sensierten Temperatur die Drehzahl des Elektromotors der Ventilatoreinrichtung mit steigender Temperatur erhöht und mit sinkender Temperatur mindert, indem sie die Frequenz eines Oszillators regelt, dessen Ausgang mit den Wicklungsspulen des Stators des bürstenlos ausgebildeten Elektromotors verbunden ist.

**2.** Vorrichtung nach Anspruch 1, **dadurch gekennzeichnet, dass** die Regelschaltung so ausgelegt ist, dass die Drehzahl des Elektromotors proportional mit einer Temperaturerhöhung des Mikroprozessors steigt.

**2.** Vorrichtung nach Anspruch 1, **dadurch gekennzeichnet, dass** die Regelschaltung so ausgelegt ist, dass die Drehzahl des Elektromotors quadratisch mit einer Temperaturerhöhung des Mikroprozessors steigt.

**3.** Vorrichtung nach Anspruch 1, **dadurch gekennzeichnet, dass** die Regelschaltung so ausgelegt ist, dass die Drehzahl des Elektromotors exponentiell mit einer Temperaturerhöhung des Mikroprozessors steigt.

**4.** Vorrichtung nach einem der Ansprüche 1 bis 3, **dadurch gekennzeichnet, dass** eine Drehzahlüberwachungseinrichtung zum Überwachen eines vorgebbaren Drehzahlbereiches des Elektromotors der Ventilatoreinrichtung vorgesehen ist.

**5.** Vorrichtung nach Anspruch 4, **dadurch gekennzeichnet, dass** die Drehzahlüberwachungseinrichtung im Zusammenwirken mit einer elektronischen Schaltung ein Warnsignal abgibt, um einen Benutzer einer mit dem Mikroprozessor betriebenen Vorrichtung zum manuellen Abschalten derselben aufzufordern, wenn der vorgegebene Drehzahlbereich der Ventilatoreinrichtung verlassen ist.

**6.** Vorrichtung nach einem der Ansprüche 4 oder 5, **dadurch gekennzeichnet, dass** die Drehzahlüberwachungseinrichtung zum Überwachen eines vorgebbaren Drehzahlbereiches des Elektromotors der Ventilatoreinrichtung eine Einrichtung enthält, die ein mit der Umdrehungsfrequenz des Elektromotors des Ventilators getaktetes Stroboskopsignal liefert, sowie eine mit einer vorgegebenen Frequenz getaktete Einrichtung zum Auswerten des Stroboskopsignals enthält.

**7.** Vorrichtung nach einem der vorhergehenden Ansprüche, **dadurch gekennzeichnet, dass** der Oszillator im Inneren der Ventilatoreinrichtung untergebracht ist.

**8.** Vorrichtung nach einem der vorhergehenden Ansprüche, **dadurch gekennzeichnet, dass** die Ventilatoreinrichtung an dem Kühlkörper des Mikroprozessors angeordnet ist.

**9.** Vorrichtung nach einem der vorhergehenden Ansprüche, **dadurch gekennzeichnet, dass** die Ventilatoreinrichtung dimensioniert ist, um in der Lage zu sein, eine Luftmenge etwa 80 m³/Stunde zu fördern.

**10.** Vorrichtung nach einem der vorhergehenden Ansprüche, **dadurch gekennzeichnet, dass** der Wärmemesssensor als NTC-Thermistor ausgeführt ist.

**11.** Vorrichtung nach einem der vorhergehenden Ansprüche, **dadurch gekennzeichnet, dass** der Wärmemesssensor als NTC-Widerstand ausgeführt ist, der funktional als Regelungsschaltung wirkt.

## Geänderte Patentansprüche

### Geänderte Patentansprüche gemäss Regel 86(2) EPÜ.

**1.** Temperatur-Überwachungsvorrichtung für Mikroprozessoren, mit einer elektromotorisch getriebenen Ventilatoreinrichtung zum Erzeugen eines Luftstromes zum Kühlen des Mikroprozessors wobei die Temperatur des Mikroprozessors mittels eines Wärmemesssensors sensierbar ist und eine Regelungsschaltung vorgesehen ist, die aufgrund der von dem Wärmemesssensor sensierten Temperatur die Drehzahl des Elektromotors der Ventilatoreinrichtung mit steigender Temperatur erhöht und mit sinkender Temperatur mindert, indem sie die Frequenz eines Oszillators regelt, dessen Ausgang mit den Wicklungsspulen des Stators des bürstenlos ausgebildeten Elektromotors verbunden ist, **dadurch gekennzeichnet, dass** der Wärmesensor in einer in dem Boden eines Kühlkörpers des Mikroprozessors ausgebildeten Bohrung angeordnet ist.
